# EUROPÄISCHE PATENTSCHRIFT

(11) **EP 1 115 677 B1**
(45) Veröffentlichungstag und Bekanntmachung des Hinweises auf die Patenterteilung: **12.11.2003**
(21) Anmeldenummer: 99947304.4
(22) Anmeldetag: 10.09.1999
(51) Int. Cl.: C04B 41/87

(54) **VERFAHREN ZUM AUSHEILEN VON RISSEN IN KERAMISCHEN FORMKÖRPERN UND DERART BEHANDELTE FORMKÖRPER**
METHOD FOR CURING CRACKS IN CERAMIC SHAPED BODIES AND SHAPED BODIES TREATED IN SUCH A MANNER
PROCEDE POUR REPARER DES FISSURES DANS DES CORPS MOULES CERAMIQUES ET CORPS MOULES TRAITES A L'AIDE DUDIT PROCEDE

(30) Priorität: 14.09.1998 DE 19841925
(43) Veröffentlichungstag der Anmeldung: 18.07.2001
(73) Patentinhaber: Nexans SuperConductors GmbH, 50351 Huerth (DE)
(72) Erfinder: BÄCKER, Michael, D-50677 Köln (DE); BOCK, Joachim, D-50374 Erftstadt (DE); FREYHARDT, Herbert, D-37085 Göttingen (DE); LEENDERS, Andreas, D-37083 Göttingen (DE); WALTER, Heribert, D-37081 Göttingen (DE); ULRICH, Martin, D-35633 Lahnau-Atzbach (DE)
(74) Vertreter: Feray, Valérie
(86) Internationale Anmeldenummer: EP9906677
(87) Internationale Veröffentlichungsnummer: WO00015581

(56) Entgegenhaltungen:
- EP-A- 0 610 556
- GB-A- 2 173 715
- US-A- 4 330 572
- PATENT ABSTRACTS OF JAPAN vol. 014, no. 413 (E-0974), 6. September 1990 (1990-09-06) & JP 02 158009 A (SUMITOMO HEAVY IND LTD), 18. Juni 1990 (1990-06-18)

## Beschreibung

Die Erfindung betrifft ein Verfahren zum Ausheilen von Rissen in keramischen Magnetwerkstoffen oder keramischen Supraleitermaterialien, das insbesonders geeignet ist, die mechanischen und ggbfs. auch die magnetischen Eigenschaften eines entsprechenden Probekörpers zu verbessern.

Das Verfahren eignet sich grundsätzlich für alle keramischen Magnetwerkstoffe oder keramischen Supraleitermaterialien, ist aber für solche höherer relativer Dichte vorgesehen. Hierdurch können die mechanischen Eigenschaften und ggbfs. auch die Oberflächenqualität insbesondere bei nachbearbeiteten Oberflächen verbessert werden. Bei supraleitenden Materialien ist es hierbei möglich, zusätzlich auch die supraleitenden und magnetischen Eigenschaften zu verbessern. in gleicher Weise ist es auch für nicht-supraleitende keramische Magnetwerkstoffe einsetzbar. Besondere Vorteile ergeben sich, wenn texturierte polykristalline oder nur wenige magnetische Domänen aufweisende supraleitende Materialien verwendet werden.

Bei spröden anorganischen Materialien sind Risse, zu denen hier auch die Mikrorisse gezählt werden, kaum vollständig vermeidbar. Sie können insbesondere aufgrund mechanischer Spannungen im Bauteil vor, während oder nach der thermischen Behandlung, aufgrund einer thermischen Behandlung, aufgrund von Gefügespannungen - vor allem bei Anwesenheit von Phasen mit deutlich unterschiedlichen thermischen Ausdehnungsunterschieden -, aufgrund von Phasenumbildungen oder aufgrund Schlag oder ähnlicher Beanspruchung auftreten.

Aus der GB-A-2,173,715 ist eine Vorrichtung zum Verschweißen in keramischen Formmassen bekannt. EP-A-610,556 beschreibt das Ausheilen lokaler Defekte durch Aufschmelzen eines keramischen Pulvers mittels Laserstrahlung. Gemäß JP-A-02/158,009 können Risse in supraleitendem Material durch Metallisieren ausgeheilt werden.

Diese Risse können makroskopisch an den Bauteilen erkennbar sein. Gerade die sich tiefer und über größere Länge erstreckenden Risse sind oft etwas breiter geöffnet und dann oft ohne visuelle Hilfsmittel oder ohne Rißtest mit Penetrationsmitteln erkennbar. Aufgrund vieler Studien ist bekannt, daß Risse einschließlich Mikrorissen die mechanischen Eigenschaften herabsetzen. Bereits an Biege- oder Zugproben können die Einflüsse von Rissen je nach Lage, Richtung und Größe studiert und ihr teilweise verheerender Einfluß ermittelt werden. Ein teilweises oder vollständiges Ausheilen der Risse kann daher die mechanischen Eigenschaften von Formkörpern einschließlich Bauteilen erheblich verbessern.

Eine andere Möglichkeit der Erkennung von Rissen ist an magnetischen Formkörpern mit Hilfe der Erfassung der Remanenzinduktion insbesondere bei zweidimensionaler Messung möglich. Hierbei tritt oft eine Trennung von magnetischen Domänen auf infolge von Rissen. Falls es möglich wäre, die durch einen Riß getrennten Gefügebestandteile bzw. Kornabschnitte, die eine gleichartige oder nahezu gleichartige Ausrichtung haben, zu verbinden und die Bereiche auszuheilen, könnten jeweils benachbarte Teildomänen zu einer neuen Domäne zusammenwachsen.

Es bestand daher die Aufgabe, ein Verfahren vorzuschlagen, mit dem die Risse in keramischen Formkörpern zumindest teilweise geschlossen werden können.

Die Aufgabe wird gelöst mit einem Verfahren zum Ausheilen von Rissen in keramischen Formkörpern, die keramische Magnetwerkstoffe oder keramische Supraleitermaterialien sind, bei dem ein Füllmaterial, das bei einer tieferen Temperatur als das Material des Formkörpers schmilzt oder/und bei einer tieferen Temperatur als jenes Material fließfähig ist, mindestens im Bereich eines Risses auf die Oberfläche des Formkörpers aufgebracht oder/und in mindestens einen Riß eingebracht wird, bei dem der Formkörper mit dem auf- oder/und eingebrachten Füllmaterial auf eine Temperatur aufgeheizt wird, bei der das Material des Formkörpers noch nicht schmilzt oder/und noch nicht fließfähig ist, aber bei der das Füllmaterial im zumindest teilweise aufgeschmolzenen und fließfähigen Zustand ist, bei dem das Füllmaterial aus nichtmetallischen oder im wesentlichen aus nichtmetallischen Verbindungen besteht und mindestens zum Teil auskristallisiert wird und bei dem der Formkörper mit dem Füllmaterial abgekühlt wird.

Wenn das Füllmaterial im wesentlichen aus nichtmetallischen Verbindungen besteht, kann noch ein Gehalt an edlen Metallen, vor allem an Silber, Gold, Platin oder/und Palladium, von insgesamt bis zu 25 Gew.-% enthalten sein. Dieser Gehalt beträgt vorzugsweise insgesamt bis zu 10 Gew.-% und tritt vor allem bei den hochtemperatursupraleitenden Materialien auf.

Das erfindungsgemäße Verfahren wird vorteilhafterweise so ausgeführt, daß das fließfähige Füllmaterial zumindest teilweise in einen Riß oder/und in einen z.B. durch Sägeschnitt entfernten Bereich des Formkörpers eindringt.

Das Material des Formkörpers ist ausgewählt aus der Gruppe der keramischen Magnetwerkstoffe, wie Hexaferriten, oder keramischen Supraleitermaterialien, insbesondere keramischen Hochtemperatursupraleitermaterialien.

Das Material des Formkörpers oder/und das Füllmaterial bestehen bevorzugt im wesentlichen aus chemischen Elementen ausgewählt aus der Gruppe von Mg, Ca, Sr, Ba, Sc, Y, La, Lanthaniden, Zr, Hf, Pt, Pd, Ag, Cu, Hg, Ag, Tl, Pb, Bi, S und O, wobei Anteile dieser chemischen Elemente durch andere, nicht genannte substituiert sein können. Als Lanthaniden kommen alle chemischen Elemente dieser Klasse in Frage.

Bevorzugt ist das Material des Formkörpers oder/und das Füllmaterial ausgewählt aus der Gruppe von Materialien auf Basis von Bi-Ea-Cu-O, (Bi,Pb)-Ea-Cu-O, Y-Ea-Cu-O, (Y,SE)-Ea-Cu-O, SE-Ea-Cu-O, TI-Ea-Cu-O, (Tl,Pb)-Ea-Cu-O und TI-(Y,Ea)-Cu-O, wobei Anteile dieser chemischen Elemente durch andere, nicht genannte substituiert sein können und wobei Ea für mindestens ein Erdalkalielement steht. Besonders günstig ist das erfindungsgemäße Verfahren, wenn ein Füllmaterial verwendet wird, bei dem mindestens zwei der Gitterparameter des Kristallgitters einer Hauptphase des Füllmaterials mit denen von einer der Hauptphasen des Materials des Formkörpers ausreichend ähnlich ist, insbesondere, um eine epitaktische Aufwachsung zu ermöglichen.

Grundsätzlich sind alle Formen von Formkörpem geeignet. Bevorzugt und derzeit gebräuchlich sind solche, die im wesentlichen in Form von Platten, Ronden, Quadern, Vollzylindern. Hohlzylindern, Ringen, Rohren oder Spulen vorliegen, wobei Winkelabweichungen, Kantenbrüche, Kantenabrundungen, zusätzliche Ausnehmungen wie z.B. Bohrungen und Nuten sowie zusätzliche vorstehende Partien wie Stege, Nasen und ähnliche geometrische Abwandlungen auftreten können.

Als Formkörper günstig ist ein angesinterter, gesinterter oder erschmolzener Keramikkörper mit einer relativen Dichte von mindestens 80 %, besonders bevorzugt von mindestens 95 %, jedoch können in Ausnahmefällen auch weniger dichte Formkörper Vorteile bieten, wenn sie erfindungsgemäß behandelt werden.

Das Füllmaterial kann einen untergeordneten Anteil eines Metalls oder mehrerer Metalle enthalten. Die Hauptphase oder die Hauptphasen des Füllmaterials sind jedoch anorganisch-nichtmetallische Verbindungen.

Als Füllmaterial eignet sich insbesondere ein Pulver oder Pulvergemisch, das ggbfs. mit bekannten Mitteln wie Wasser oder/und anderen Lösungsmitteln, Plastifizierungsmitteln usw. in altbekannter Weise angesetzt sein kann, das oberflächlich auf- oder/und in die Risse bzw. entfernten Bereiche eingebracht werden kann. Als Füllmaterial eignet sich auch besonders ein gepreßter, kalzinierter, gesinterter oder erschmolzener Formkörper, der auf den Formkörper gesetzt oder an ihm befestigt wird. Besonders bevorzugt ist eine Kombination von Pulver/Pulvergemisch mit einem derartig angebrachten Formkörper. Das Füllmaterial kann jedoch auch, ggbfs. zusätzlich, in Form einer Beschichtung aufgebracht werden, wobei grundsätzlich alle bekannten Beschichtungsverfahren geeignet sind, aber auf die erforderliche Schichtdicke bezüglich der Auswahl des Beschichtungsverfahrens zu achten ist.

Das Füllmaterial weist vorzugsweise einen Schmelzpunkt auf, der um mindestens 5 °C niedriger liegt als der des Materials des Formkörpers, besonders bevorzugt um mindestens 10 °C, ganz besonders bevorzugt um mindestens 20 °C. Die Differenz der Schmelzpunkte muß um so größer sein, je weniger genau die Temperatur beim Brand kontrolliert werden kann oder/und je stärker die Temperaturschwankungen innerhalb des Besatzraumes eines Ofens, insbesondere während der Haltezeit, sind.

Das Füllmaterial weist vorzugsweise ein Erweichungsverhalten auf derart, daß es bei einer Temperatür zumindest teilweise aufgeschmolzen und fließfähig ist, die mindestens 10°C, besonders bevorzugt mindestens 20°C, ganz besonders bevorzugt mindestens 30 °C tiefer. Liegt, als die Temperatür, bei der das Material des Formkörpers eine derartige Viskosität aufweist. Hierbei ist zu beachten, daß die Viskosität des fließfähigen Füllmaterials bzw. des Materials des Formkörpers wesentlich durch ein stützendes Gerüst aus festen, ggbfs. miteinander verbundenen Partikeln beeinflußt sein kann. Es muß für den verwendeten Ofen und den gewählten Besatz sichergestellt sein, daß das Material des Formkörpers bei der gewählten Behandlungstemperatur noch ausreichend formbeständig bleibt, während das Füllmaterial eine so geringe Viskosität aufweist, daß es ausfließen und in zumindest breite Risse und in breite entfernte Bereiche eindringen kann, aber auch nicht so dünnflüssig ist, daß es nach dem Eindringen wieder aus den Rissen herauskriechen und diese unverfüllt lassen kann. In letzterem Fall kann es daher von Bedeutung sein, die Viskosität durch Änderung der chemischen Zusammensetzung oder Herabsetzung der Temperatur zu steigern, insbesondere, wenn die Risse oder die entfernten Bereiche eine größere Breite aufweisen.

Ein Unterschied in der Schmelztemperatur oder/und im Erweichungsverhalten kann auf unterschiedliche Weise eingestellt werden:
- Es kann ein artfremdes oder im wesentlichen artfremdes Material mit entsprechenden physikochemischen Eigenschaften als Füllmaterial eingesetzt werden wie z.B. ein mit mehreren Gewichtsprozent SiO₂ oder/und MgO versetztes Aluminiumoxidmaterial.
   Eine gewisse chemische Affinität oder/und Reaktivität zwischen Füllmaterial und Material des Formkörpers ist dabei von Vorteil.
- Es kann ein arteigenes oder im wesentlichen arteigenes Material eingesetzt werden.

Das Füllmaterial kann einen niedrigeren Schmelzpunkt bzw. eine niedrigere Viskosität als das Material des Formkörpers aufweisen, weil das Füllmaterial z.B. aufgrund:
- eines höheren Gehalts eines gleichen Additivs wie im Material des Formkörpers, das den Schmelzpunkt bzw. die Viskosität absenkt, z.B. unter eutektischen oder peritektischen Verhältnissen und der gleichen Hauptphase(n) wie im Material des Formkörpers,
- eines Gehalts an einem Additiv, das nur untergeordnet oder gar nicht im Material des Formkörpers enthalten ist, das den Schmelzpunkt bzw. die Viskosität absenkt, z.B. unter eutektischen oder peritektischen Verhältnissen, und aufgrund des Gehalts der gleichen Hauptphase(n),
- eines höheren Gehalts eines gleichen Additivs wie im Material des Formkörpers, das den Schmelzpunkt bzw. die Viskosität absenkt, z.B. unter eutektischen oder peritektischen Verhältnissen, aber bei Anwesenheit anderer Hauptphasen als im Material des Formkörpers,
- dessen, daß die Hauptphase(n) des Füllmaterials identisch oder im wesentlichen identisch ist/sind mit mindestens einem Additiv im Material des Formkörpers, das den Schmelzpunkt bzw. die Viskosität absenkt, z.B. unter eutektischen oder peritektischen Verhältnissen,
- dessen, daß die Hauptphase(n) des Füllmaterials eine durch partielle Substitution oder Austausch verwandter chemischer Elemente geänderte chemische Zusammensetzung aufweist/aufweisen wie die Hauptphase(n) im Material des Formkörpers, wobei diese Änderung den Schmelzpunkt bzw. die Viskosität absenkt, z.B. unter eutektischen oder peritektischen Verhältnissen.

Wenn supraleitende Materialien eingesetzt werden, so kann das Füllmaterial z.B. reicher sein an Elementen, substituierten Elementen bzw. Additiven, die den Schmelzpunkt bzw. die Viskosität absenken.

Für ein Füllmaterial auf Basis YBCO ist es beispielsweise vorteilhaft möglich, anstelle von Yttrium teilweise oder gänzlich Ytterbium oder/und auch andere tiefer schmelzende oder/und niedrigviskosere Verbindungen ergebende Lanthaniden einzusetzen. Hierbei ist zu beachten, daß die jeweiligen Verbindungen SE₁Ba₂Cu₃Oᵥ bzw. Y₁Ba₂Cu₃Oᵥ Schmelzpunkte bei jeweils etwa 1085 °C, 1060 °C, 1000 °C und 900 °C aufweisen in der Reihenfolge von Nd, Sm, Y bzw. Yb für die 123-Phase. Daher kann bei einem Material eines Formkörpers auf Basis NdBCO für ein arteigenes oder artähnliches Füllmaterial Nd teilweise oder gänzlich durch Sm, Y oder/und Yb ersetzt sein.

Für ein Füllmaterial auf Basis BSCCO ist es beispielsweise vorteilhaft möglich, anstelle von Wismut teilweise Blei oder Antimon bzw. ein geändertes Sr: Ca-Verhältnis einzusetzen. Ein Material des Formkörpers auf Basis BSCCO mit einem Gehalt von mehr als 8 Gew.-% eines hochschmelzenden Erdalkalisulfats wie z.B. SrSO₄ hat allein aufgrund eines Gerüstes aus Sulfatpartikeln eine höhere Viskosität, so daß ein Erdalkalisulfat-freies BSCCO-Material als Füllmaterial verwendet werden kann.

Für ein Füllmaterial auf Basis von Tl-Supraleitern ist es beispielsweise vorteilhaft möglich, anstelle von Thallium teilweise Blei oder Antimon bzw. ein geändertes Ba: Ca - Verhältnis einzusetzen.

Das Auskristallisieren des Füllmaterials kann bereits bei Behandlungstemperatur auftreten, insbesondere, wenn es zu chemischen Reaktionen im Füllmaterial oder/und mit dem Material des Formkörpers kommt. In den meisten Fällen wird das Auskristallisieren des Füllmaterials bei geringfügig abgesenkter Temperatur, vorzugsweise entweder bei einem langsamen Abkühlen oder bei einer entsprechend gewählten Temperaturrampe erfolgen. Das zumindest teilweise Auskristallisieren ist vorteilhaft, um ein besonders mechanisch stabiles Gefüge oder möglichst einkristalline Bereiche auszubilden, die sich auch auf die anderen Eigenschaften des Formkörpers, z.B. auf die magnetischen Eigenschaften, vorteilhaft auswirken. Besonders vorteilhaft ist die Auskristallisation, wenn sie epitaktisch auf dem Material des Formkörpers erfolgt. Hierzu ist in manchen Fällen eine besonders lange Haltezeit oder/und ein besonders langsames Abkühlen hilfreich, um sowohl eine Keimbildung, als auch ein ungestörtes epitaktisches Aulwachsen zu ermöglichen. Je besser sich die Orientierung des kristallisierten Füllmaterials an die des benachbarten Materials des Formkörpers anpaßt, umso besser werden die erzielten Eigenschaften des erfindungsgemäßen Formkörpers sein. Dabei ist es von Vorteil, wenn das kristallisierte Füllmaterial möglichst weit in die Tiefe des Risses oder entfernten Bereichs hineinragt.

In einer bevorzugten Ausgestaltung, vor allem, wenn ein nur wenige Kömer oder/und ein nur wenige magnetische Domänen aufweisender Formkörper vorliegt, wird ein Riß, eine Komgrenze oder/und ein verunreinigter oder strukturell gestörter Bereich entfernt, insbesondere durch Sägen, wobei der entfernte Bereich danach im weiteren erfindungsgemäßen Verfahren wie ein Riß behandelt wird. Hierdurch ist es u.a. möglich, fehlerhafte Formkörper gänzlich auszuheilen oder besonders große Formkörper mit besseren Eigenschaften als derzeit technisch möglich herzustellen.

In manchen Fällen kann es genügen, wenn der Riß nur oberflächlich geschlossen wird, insbesondere bei besonders schmalen Rissen. Vorteilhafterweise werden jedoch mindestens einzelne der Risse und der entfernten Bereiche auch in der Tiefe zumindest teilweise verfüllt, was dadurch erfolgen kann, daß der Formkörper mit dem Füllmaterial zumindest so lange auf der Temperatur gehalten wird, daß zumindest ein teilweises Eindringen des fließfähigen Füllmaterials in einen breiteren Riß oder in einen entfernten Bereich möglich ist. Je mehr die Fläche des Risses oder des entfernten Bereichs verfüllt wird, desto stärker verbessern sich die magnetischen Eigenschaften eines supraleitenden Materials. Daher ist es vorteilhaft, zumindest die oberen 3 mm, vorzugsweise mindestens die oberen 5 mm, besonders bevorzugt mindestens die oberen 8 mm von der Oberfläche in die Tiefe des Formkörpers erfindungsgemäß zu behandein und Risse und entfernte Bereiche bis in diese Tiefe so weit als möglich zu verfüllen.

Bei manchen Kombinationen Material des Formkörpers - Füllmaterial ist es angebracht, die Haltezeit bei maximaler Temperatur der erfindungsgemäßen Behandlung im Bereich von mindestens 5 Minuten bis maximal 2 Stunden, vorzugsweise von mindestens 10 Minuten bis maximal 1 Stunde, zu begrenzen, insbesondere, um das fließfähige Füllmaterial ausfließen zu lassen, aber ein Erweichen des Formkörpers zu verhindern.

Bei anderen Kombinationen Material des Formkörpers - Füllmaterial kann dagegen die Haltezeit bei maximaler Temperatur der erfindungsgemäßen Behandlung nahezu Null sein, wenn die Schmelzpunkte oder/und die Erweichungstemperaturen der jeweiligen Hauptphasen sehr weit auseinander liegen und die Auf- und Abheizgeschwindigkeit für ein Ausfließen des Füllmaterials etwa im Bereich der höchsten Temperaturen ausreicht.

Wenn ein Erweichen des Formkörpers bei der maximalen Temperatur der erfindungsgemäßen Behandlung nicht absehbar ist, kann die Haltezeit auch entsprechend länger gewählt werden.

Das erfindungsgemäße Verfahren verläuft üblicherweise besonders günstig, wenn die thermischen Kristallisationsbedingungen für das Füllmaterial so gewählt werden, daß das Füllmaterial epitaktisch auf der Rißfläche, auf der Oberfläche eines entfernten Bereiches oder/und der Oberfläche des Formkörpers aufwächst. Das gilt insbesonders für Formkörper mit einem oder wenigen Körnern bzw. magnetischen Domänen, da das Ausheilen des Bereichs der Trennstelle (Riß, Bereich mit Verunreinigungen oder/und strukturellen Störungen usw.) dann die Eigenschaften des Formkörpers stark verbessert, insbesondere wenn ein hoher Verfüllungsgrad erreicht wird.

Bei supraleitenden Materialien wird es oft erforderlich sein, daß der Formkörper mit dem erhitzten Füllmaterial in einem Sauerstoff enthaltenden Gas thermisch nachbehandelt wird, um die supraleitenden Eigenschaften zu verbessern.

Für Formkörper, deren Oberflächen eine bestimmte Oberflächengüte, z.B. einen Mittenrauhwert Rₐ bestimmter Größe oder als Funktionsflächen eine bestimmte Form der Abbot'schen Tragkurve, erfordern oder bei deren Geometrie bestimmte Maße von Längen, Winkeln oder/und Form- und Lagetoleranzen wie z.B. Ebenheit oder Parallelität eingehalten werden sollen, wird es oft notwendig sein, daß der Formkörper mit dem erhitzten Füllmaterial nach dem Abkühlen oberflächlich mechanisch nachbearbeitet wird, z.B. durch Schleifen, Läppen, Polieren oder/und Trommeln. Hierbei kann es auch sinnvoll sein, scharfe Kanten durch Schleifen mit einer Fase oder Verrundung bzw. durch Trommeln mit einer Verrundung zu versehen.
Um die magnetischen Eigenschaften bei Hartferriten oder Supraleitern zu verbessern, kann es vorteilhaft sein, daß ein Formkörper verwendet wird, der nur wenige magnetische Domänen aufweist. Durch das erfindungsgemäße Verfahren kann die Zahl dieser Domänen verringert und können die magnetischen Eigenschaften, insbesondere die Levitationskraft und die maximale Remanenzinduktion, verbessert werden.

Derartige, nur mit einem Korn oder mit wenigen Körnern bzw. mit nur einer magnetischen Domäne oder mit wenigen magnetischen Domänen versehenen Formkörper werden vorzugsweise in einem modifizierten Schmelztexturwachstumsprozeß, in einem Schmelzwachstumsprozeß mit oben sitzendem Keim oder in einem Zonenschmelzprozeß hergestellt. Probekörper, die in einem dieser Verfahren hergestellt wurden, weisen oft nur etwa ein bis sechs magnetische Domänen auf. Wenn derartige Proben Risse oder/und verunreinigte oder strukturell gestörte Bereiche ausweisen, können diese Defekte mit dem erfindungsgemäßen Verfahren ausgeheilt und auch die aufgespaltenen magnetischen Domänen ausgeheilt werden.

Als hochtemperatursupraleitende Materialien eignen sich für das erfindungsgemäße Verfahren solche, bei denen das Material des Formkörpers oder/und das Füllmaterial Phasen enthält, die ausgewählt sind aus der Gruppe von Phasen mit einer annähernden Zusammensetzung von Y₁Ba₂Cu₃Oᵥ, Y₂Ba₁Cu₁O_{w}, Yb₁Ba₂Cu₃O_{v'}, Yb₂Ba₁Cu₁O_{w'}, Sm₁Ba₂Cu₃O_{v"}, Sm₂Ba₁Cu₁O_{w"}, Nd₁Ba₂Cu₃O_{v"'}, Nd₄Ba₂Cu₂O_{w"'}, Y₂O₃, CeO₂, PtO₂, Ag und AgO₂, wobei Y, Yb, Sm oder/und Nd teilweise auch durch andere Lanthaniden oder Y substituiert sein können und wobei in Ag oder/und AgO₂ auch andere verwandte chemische Elemente auftreten können.

Das Material eines hochtemperatursupraleitenden Formkörpers oder/und das Füllmaterial kann Phasen enthalten, die ausgewählt sind aus der Gruppe von Phasen mit einer annähernden Zusammensetzung von Bi₂(Sr,Ca)₂Cu₁Oₓ, (Bi,Pb)₂(Sr,Ca)₂Cu₁O_{x'}, Bi₂(Sr,Ca)₃Cu₂O_{x"}, (Bi,Pb)₂(Sr,Ca)₃Cu₂O_{x"'}, Bi₂(Sr,Ca)₄Cu₃O_{x""}, (Bi,Pb)₂(Sr,Ca)₄Cu₃O_{x""'}, wobei Bi, Pb, Sr und Ca teilweise auch durch einzelne andere chemische Elemente substituiert sein können.

Ferner kann das Material eines hochtemperatursupraleitenden Formkörpers oder/und das Füllmaterial Phasen enthalten, die ausgewählt sind aus der Gruppe von Phasen mit einer annähernden Zusammensetzung von (Tl,Pb)₂(Ba,Ca)₂Cu₁O_{y}, (Tl,Pb)₂(Ca,Ba)₄Cu₃O_{y'}, (Tl,Pb)₂(Ca,Ba)₃Cu₄O_{y"}, (Tl,Pb)₁(Ca,Ba)₃Cu₂O_{y"'},und (Tl,Pb)₁(Ca,Ba)₄Cu₃O_{y""}, wobei einzelne der aufgeführten chemischen Elemente teilweise durch andere chemische Elemente substituiert sein können.

Es ist bekannt, daß alle diese supraleitenden Phasen oft eine Zusammensetzung aufweisen, die von der Stöchiometrie der jeweiligen allgemeinen Formel signifikant abweicht. Die Zusammensetzung dieser Phasen und die Substitution durch andere chemische Elemente ist dem Fachmann grundsätzlich bekannt.

Die erfindungsgemäß hergestellten Formkörper können beispielsweise für Transformatoren, Stromunterbrecher, Stromzuführungen, magnetische Abschirmungen, magnetische Lager oder/und als Magnete für unterschiedliche Zwecke verwendet werden.

### Beispiele:

Im folgenden wird die Erfindung beispielhaft dargestellt:

### Beispiel 1

Das Material eines Formkörpers auf der Basis der hochtemperatursupraleitenden Ausgangszusammensetzung Y₁Ba₂Cu₃Oᵥ mit 25 mol% Y₂O₃ und 1 mol% CeO₂ wurde bei Temperaturen bis 1045 °C durch einen Schmelzwachstumsprozeß mit oben sitzendem Keim (top-seeded-melt-growth TSMG) hergestellt. Das Gefüge bestand aus YBCO 123 mit einer hohen Dichte an feinsten Partikeln von YBCO 211. Etliche Probekörper hatten die Form einer Platte von 38 × 38 mm und 12 mm Höhe, von denen zwei Probekörper seitlich der Mitte oder nahezu mittig einen tiefen, ca. 10 µm breiten, im wesentlichen gerade verlaufenden Riß aufwiesen. Dieser Riß beeinträchtigte die magnetischen Eigenschaften der entsprechenden Probekörper. Die bildliche Darstellung der Remanenzinduktion über die große Fläche der Platte zeigte jeweils einen deutlichen Eigenschaftsabfall im Bereich des Risses.

Es wurde ein Füllmaterial der Ausgangszusammensetzung Yb₁Ba₂Cu₃Oᵥ durch Feinmahlung in ein sehr feinkömiges Pulver überführt, das in Form eines dünnen Bandes über den Riß auf die Oberfläche des Probekörpers gestreut wurde. Dabei wurde das Füllmaterial in einem sehr hohen Volumenüberschuß gegeben, was möglicherweise auch den Vorteil hat, daß Ytterbium aufgrund von Diffusion in das YBCO-Kristallgitter eingebaut werden kann. Die so vorbereiteten Probekörper wurden zusammen mit dem Füllmaterial bis auf 970 °C erhitzt, dort 12 Minuten gehalten und danach abgeheizt, wobei bei 943, 940 und 900 °C jeweils eine zehn- bzw. fünfzigstündige Haltezeit gehalten wurde und dazwischen auch in 50 Stunden langsam heruntergefahren wurde, um eine Keimbildung und möglichst epitaktische Kristallisation zu bewirken. Diese Zeiten können jedoch noch deutlich abgesenkt werden. Danach wurde langsam auf Raumtemperatur abgekühlt. Die Haltezeit bei Maximaltemperatur wurde vergleichsweise kurz gehalten, um ein spürbares Wachstum von Y₂Ba₁Cu₁O_{w}-Partikeln sowie ein Erweichen des Probekörpers zu vermeiden.

Die so ausgeheilten Probekörper zeigten einen gut und gleichmäßig verfüllten Riß, auch im untersten Teil des Risses, und wiesen jetzt bei der Messung der Remanenzinduktion ein gleichmäßiges Bild der magnetischen Eigenschaften auf, das nur noch eine einzige magnetische Domäne ohne jegliche Störung oder Beeinträchtigung zeigt. Während die magnetische Remanenzinduktion vor dem Ausheilen des seitlich die Probe durchlaufenden Risses bei dem einen Probekörper 625 mT betrug, konnte sie durch das Ausheilen auf 644 mT gesteigert werden.

## Patentansprüche

1. Verfahren zum Ausheilen von Rissen in keramischen Formkörpern, die keramische Magnetwerkstoffe oder keramische Supraleitermaterialien sind, bei dem ein Füllmaterial, das bei einer tiefaren Temperatur als das Material des Formkörpers schmilzt oder/und bei einer tieferen Temperatur als jenes Material fließfähig ist, mindestens im Bereich eines Risses auf die Oberfläche des Formkörpers aufgebracht oder/und in mindestens einen Riß eingebracht wird, bei dem der Formkörper mit dem auf- oder/und eingebrachten Füllmaterial auf eine Temperatur aufgeheizt wird, bei der das Material des Formkörpers noch nicht schmilzt oder/und noch nicht fließfähig ist, aber bei der das Füllmaterial im zumindest teilweise aufgeschmolzenen und fließfähigen Zustand ist, bei dem das Füllmaterial aus nichtmetallischen oder im wesentlichen aus nichtmetallischen Verbindungen besteht und mindestens zum Teil auskristallisiert wird, und bei dem der Formkörper mit dem Füllmaterial abgekühlt wird

2. Verfahren nach Anspruch 1, **dadurch gekennzeichnet, daß** das Material des Formkörpers ein keramischer Hochtemperatursupraleitermaterial ist.

3. Verfahren nach Anspruch 2, **dadurch gekennzeichnet, daß** das Material des Formkörpers oder/und das Füllmaterial im wesentlichen aus Elementen besteht ausgewählt aus der Gruppe von Mg, Ca, Sr, Ba, Sc, Y, La, Lanthaniden, Zr, Hf, Pt, Pd, Ag, Cu, Hg, Ag, TI, Pb, Bi, S und O.

4. Verfahren nach Anspruch 2 oder 3, **dadurch gekennzeichnet, daß** das Material des Formkörpers oder/und das Füllmaterial ausgewählt ist aus der Gruppe von Materialien auf Basis von Bi-Ea-Cu-O, (Bi,Pb)-Ea-Cu-O, Y-Ea-Cu-O, (Y,SE)-Ea-Cu-O, SE-Ea-Cu-O, Tl-Ea-Cu-O, (Tl,Pb)-Ea-Cu-O und Tl-(Y,Ea)-Cu-O, wobei Ea für mindestens ein Erdalkalielement steht.

5. Verfahren nach einem der Ansprüche 1 bis 4, **dadurch gekennzeichnet, daß** ein Füllmaterial verwendet wird, bei dem mindestens zwei der Gitterparameter des Kristallgitters einer der Hauptphasen des Füllmaterials mit denen von einer der Hauptphasen des Materials des Formkörpers ausreichend ähnlich ist.

6. Verfahren nach einem der Ansprüche 1 bis 5, **dadurch gekennzeichnet, daß** der Formkörper im wesentlichen in Form von Platten, Ronden, Quadern, Vollzylindern, Hohlzylindern, Ringen, Rohren oder Spulen vorliegt.

7. Verfahren nach einem der Ansprüche 1 bis 6, **dadurch gekennzeichnet, daß** der Formkörper ein angesinterter, gesinterter oder erschmolzener Keramikkörper mit einer relativen Dichte von mindestens 80 % ist, vorzugsweise von mindestens 90 %.

8. Verfahren nach einem der Ansprüche 1 bis 7, **dadurch gekennzeichnet, daß** als Füllmaterial ein Pulver auf- oder/und eingebracht wird oder/und ein gepreßter, kalzinierter, gesinterter oder erschmolzener Formkörper oder/und eine Beschichtung aufgebracht wird.

9. Verfahren nach einem der Ansprüche 1 bis 8, **dadurch gekennzeichnet, daß** ein Riß, eine Korngrenze oder/und ein verunreinigter oder strukturell gestörter Bereich entfernt wird, insbesondere durch Sägen, und daß der entfernte Bereich danach wie ein Riß behandelt wird.

10. Verfahren nach einem der Ansprüche 1 bis 9, **dadurch gekennzeichnet, daß** der Formkörper mit dem Füllmaterial zumindest so lange auf dieser Temperatur gehalten wird, daß zumindest ein teilweises Eindringen des erschmolzenen Füllmaterials in einen breiteren Riß oder in einen entfernten Bereich möglich ist.

11. Verfahren nach einem der Ansprüche 1 bis 10, **dadurch gekennzeichnet, daß** die thermischen Kristallisationsbedingungen für das Füllmaterial so gewählt werden, daß das Füllmaterial epitaktisch auf der Rißfläche, der Oberfläche eines entfernten Bereiches oder/und der Oberfläche des Formkörpers aufwächst.

12. Verfahren nach einem der Ansprüche 2 bis 11, **dadurch gekennzeichnet, daß** der Formkörper beim Abkühlen oder/und bei einer nachfolgenden Wärmebehandlung mit Sauerstoff angereichert wird und bei dem eine supraleitfähige Phase ausgebildet wird

13. Verfahren nach einem der Ansprüche 2 bis 12, **dadurch gekennzeichnet, daß** der Formkörper mit dem erhitzten Füllmaterial in einem Sauerstoff enthaltenden Gas thermisch nachbehandelt wird, um die supraleitenden Eigenschaften zu verbessern.

14. Verfahren nach einem der Ansprüche 1 bis 13, **dadurch gekennzeichnet, daß** der Formkörper mit dem erhitzten Füllmaterial oberflächlich mechanisch nachbearbeiret wird.

15. Verfahren nach einem der Ansprüche 1 bis 14, **dadurch gekennzeichnet. daß** ein Formkörper verwendet wird, der nur wenige magnetische Domänen aufweist.

16. Verfahren nach einem der Ansprüche 1 bis 15, **dadurch gekennzeichnet, daß** ein Formkörper verwendet wird, der in einem modifizierten Schmelztexturwachstums-prozeß oder in einem Schmelzwachstumsprozeß mit oben sitzendem Keim hergestellt wurde.

17. Verfahren nach einem der Ansprüche 1 bis 16, **dadurch gekennzeichnet, daß** aufgespaltene magnetische Domänen ausgeheilt werden.

18. Verfahren nach einem der Ansprüche 1 bis 17, **dadurch gekennzeichnet, daß** das Material des Formkörpers oder/und das Füllmaterial Phasen enthält, die ausgewählt sind aus der Gruppe von Phasen mit einer annähernden Zusammensetzung von Y₁Ba₂Cu₃O_{v"}, Y₂Ba₁Cu₁O_{w}, Yb₁Ba₂Cu₃O_{v'}, Yb₂Ba₁Cu₁O_{w'}, Sm₁Ba₂Cu₃O_{v"}, Sm₂Ba₁Cu₁O_{w"}, Nd₁Ba₂Cu₃O_{v"'}, Nd₄Ba₂Cu₂O_{w"'}, Y₂O₃, CeO₂, PtO₂, Ag und AgO₂, wobei Y, Yb, Sm oder/und Nd teilweise auch durch andere Lanthaniden oder Y substituiert sein können und wobei in Ag oder/und AgO₂ auch andere verwandte chemische Elemente auftreten können.

19. Verfahren nach einem der Ansprüche 1 bis 17, **dadurch gekennzeichnet, daß** das Material des Formkörpers oder/und das Füllmaterial Phasen enthält, die ausgewählt sind aus der Gruppe von Phasen mit einer annähernden Zusammensetzung von Bi₂(Sr,Ca)₂Cu₁Oₓ, (Bi,Pb)₂(Sr,Ca)₂Cu₁O_{x'}, Bi₂(Sr,Ca)₃Cu₂O_{x"}, (Bi,Pb)₂(Sr,Ca)₃Cu₂O_{x"'}, Bi₂(Sr,Ca)₄Cu₃O_{x""}, (Bi,Pb)₂(Sr,Ca)₄Cu₃O_{x""'}, wobei Bi, Pb, Sr und Ca teilweise auch durch einzelne andere chemische Elemente substituiert sein können.

20. Verfahren nach einem der Ansprüche 1 bis 17, **dadurch gekennzeichnet, daß** das Material des Formkörpers oder/und das Füllmaterial Phasen enthält, die ausgewählt sind aus der Gruppe von Phasen mit einer annähernden Zusammensetzung von (Tl,Pb)₂(Ba,Ca)₂Cu₁O_{y}, (Tl,Pb)₂(Ca,Ba)₄Cu₃O_{y'}, (Tl,Pb)₂(Ca,Ba)₃Cu₄O_{y"}, (Tl,Pb)₁(Ca,Ba)₃Cu₂O_{y"'} und (Tl,Pb)₁(Ca,Ba)₄Cu₃O_{y""}, wobei einzelne der aufgeführten chemischen Elemente teilweise durch andere chemische Elemente substituiert sein können.

21. Formkörper mit nur einem oder bis zu 8 Körnern, bei dem mindestens ein Riß oder/und mindestens ein verunreinigter oder strukturell gestörter Bereich, der zuvor beispielsweise durch Sägen aus dem Formkörper entfernt wurde, mit dem Verfahren nach einem der Ansprüche 1 bis 20 ausgeheilt wurde.

22. Magnetischer Formkörper mit nur einer oder bis zu 8 magnetischen Domänen, bei dem mindestens ein Riß oder/und ein verunrainigter oder strukturell gestörter Bereich, der zuvor beispielsweise durch Sägen aus dem Formkörper entfernt wurde, mit dem Verfahren nach einem der Ansprüche 1 bis 20 ausgeheilt wurde.

23. Verwendung eines Formkörpers hergestellt nach einem der Ansprüche 2 bis 15 für Transformatoren, Stromunterbrecher, Stromzuführungen, magnetische Abschirmungen, magnetische Lager oder/und als Magnete.

## Claims

1. A method for healing cracks in ceramic molded bodies, which are ceramic magnetic materials or ceramic superconductors, whereby a filler material, which melts at a lower temperature than the material of the molded body and / or is fusible at a lower temperature than said material and is applied to at least the surface of the molded body in the zone of a crack and / or incorporated into at least one crack, whereby the molded body with the applied and / or incorporated filler material is heated to a temperature, at which the material of the molded body does not yet melt and / or is not yet fusible but at which the filler material is at least partially in a melted or fusible state and in which the filler material comprised of non-metallic or of substantially non-metallic compounds and is at least in part crystallized out and whereby the molded body is cooled with the filler material.

2. The method according to Claim 1, **characterized in that** the material of the molded body is a ceramic high-temperature superconductor material.

3. The method according to Claim 2, **characterized in that** the material of the molded body and / or the filler material is substantially comprised of elements chosen from the group comprising : Mg, Ca, Sr, Ba, Sc, Y, La, lanthanides, Zr, Hf, Pt, Pd, Ag, Cu, Hg, Ag, Tl, Pb, Si, S and O.

4. The method according to Claim 2 or 3, **characterized in that** the material of the molded body and / or the filler material is chosen from the group of materials based on Bi-Ea-Cu-O, (Bi,Pb)-Ea-Cu-EO, Y-Ea-Cu-O, (Y,SE)-Ea-Cu-O, SE-Ea-Cu-O, TlEa-Cu-O, (Tl,Pb)-Ea-Cu-O and Tl(Y,Ea)-Cu-O, wherein Ea is defined as an alkaline earth element.

5. The method according to one of Claims 1 to 4, **characterized in that** a filler material is used, wherein at least two of the lattice parameters of the crystal lattice of one of the main phases of the filler material is sufficiently similar to those of one of the main phases of the material of the molded body.

6. The method according to one of Claims 1 to 5, **characterized in that** the molded body is essentially in the form of plates, round plates, cuboids, solid cylinders, hollow cylinders, rings, tubes or spools.

7. The method according to one of Claims 1 to 6, **characterized in that** the molded body is a pre-sintered, sintered, or fused ceramic body having a relative density of at least 80 %, preferably of at least 90 %.

8. The method according to one of Claims 1 to 7, **characterized in that** a powder is applied and / or incorporated as filler material and / or a pressed, calcined, sintered or fused molded body and / or a coating.

9. The method according to one of Claims 1 to 8, **characterized in that** a crack, a grain boundary and / or a contaminated or structurally imperfect area is removed, in particular by sawing, and that the removed area is thereafter treated as a crack.

10. The method according to one of Claims 1 to 9, **characterized in that** the molded body with the filler material is held at this temperature until at least partial penetration of the molten filler material into a wider crack or into a removed area is possible.

11. The method according to one of Claims 1 to 10, **characterized in that** the thermal crystallization conditions for the filler material are chosen so that the filler material grows epitactically on the crack surface, the surface of a removed area or / and the surface of the molded body.

12. The method according to one of Claims 2 to 11, **characterized in that** the molded body, at the time of cooling and / or at the time of subsequent heat treatment, is enriched with oxygen and wherein a superconductive phase is created.

13. The method according to one of Claims 2 to 12, **characterized in that** the molded body is re-treated using a heated filler material in an oxygen-containing gas in order to improve the superconducting properties.

14. The method according to one of Claims 1 to 13, **characterized in that** the molded body is mechanically re-worked on its surface using the heated filler material.

15. The method according to one of Claims 1 to 14, **characterized in that** a molded body is used, which has only few magnetic domains.

16. The method according to one of Claims 1 to 15, **characterized in that** a molded body is used, which is manufactured using a modified melt texture growth process or in a melt growth process using a top-seated seed.

17. The method according to one of Claims 1 to 16, **characterized in that** split-up magnetic domains are healed.

18. The method according to one of Claims 1 to 17, **characterized in that** the material of the molded body and / or the fill material comprise(s) phases, that are chosen from the group comprising phases with an approximate composition of Y₁Ba₂Cu₃Oᵥ₁, Y₂Ba₁Cu₁O_{w1}, Yb₁Ba₂Cu₃O_{v'}, Yb₂Ba₁Cu₁O_{w'}, Sm₁Ba₂Cu₃O_{v"}, Sm₂Ba₁Cu₁O_{w"}, Nd₁Ba₂Cu₃O_{v"'}, Nd₄Ba₂Cu₂O_{w" '}, Y₂O₃, CaO₂, PtO₂, Ag and AgO₂, wherein Y, Yb, Sm and / or Nd can also be in part replaced by other lanthanides or Y and wherein in Ag and / or AgO₂ also other chemical elements used can occur.

19. The method according to one of Claims 1 to 17, **characterized in that** the material of the molded body and / or the filler material contains phases that are chosen from the group of phases having the approximate composition of Bi₂(Sr,Ca)₂Cu₁Oₓ, (Bi,Pb)₂(Sr,Ca)₂CU₁Oₓ, Bi₂(Sr,Ca)₃Cu₂O_{x"}, (Bi,Pb)₂(Sr,Ca)₃Cu₂O_{x"}, Bi₂(Sr,Ca)₄Cu₃O_{x"'}, (Bi,Pb)₂(Sr,Ca)₄Cu₃O_{x" "}, wherein Bi, Pb, Sr and Ca can also be substituted with other single chemical elements.

20. The method according to one of Claims 1 to 17, **characterized in that** the material of the molded body and / or the filler material contains phases that are chosen from the group of phases having the approximate composition of (Tl,Pb)₂(Ba,Ca)₂Cu₁O_{y}, (Tl,Pb)₂(CaBa)₄Cu₃O_{y}, (Tl,Pb)₂(Ca,Ba)₃Cu₄O_{y}, (Tl,Pb)₁(Ca,Ba)₃Cu₂O_{y"} and (Tl,Pb)₁(Ca,Ba)₄Cu₃O_{y"'}, wherein individual chemical elements of those listed can be substituted with other chemical elements.

21. Molded bodies with only one or up to 8 grains, wherein at least one crack and / or at least one contaminated or structurally imperfect area, which previously has been removed from the molded body by sawing, for example, is healed using the method according to one of Claims 1 to 20.

22. Magnetic molded bodies with only one or up to 8 magnetic domains, wherein at least one crack and / or one contaminated or structurally imperfect area, which previously has been removed from the molded body by sawing, for example, is healed using the method according to one of Claims 1 to 20.

23. The use of a molded body manufactured according to one of Claims 2 to 15 for transformers, current breakers, current lines, magnetic shielding, magnetic storage and / or as magnets.

## Revendications

1. Procédé destiné à réparer ou à remédier à des fissures dans des corps façonnés en céramique, qui sont des matériaux magnétiques céramiques ou des matériaux supraconducteurs céramiques,
d'après lequel un matériau de remplissage, qui fond à une température plus basse que le matériau du corps façonné ou/et est fluide à une température plus basse que ledit matériau cité en dernier, est appliqué sur la surface du corps façonné au moins dans la région d'une fissure ou/et est introduit dans au moins une fissure,
d'après lequel le corps façonné avec le matériau de remplissage appliqué ou/et introduit est chauffé à une température pour laquelle le matériau du corps façonné ne fond pas encore ou/et n'est pas encore fluide, mais pour laquelle le matériau de remplissage est dans l'état au moins partiellement fondu et fluide,
d'après lequel le matériau de remplissage est constitué de composés non métalliques ou essentiellement de composés non métalliques, et est au moins en partie cristallisé, et
d'après lequel le corps façonné est refroidi avec le matériau de remplissage.

2. Procédé selon la revendication 1, **caractérisé en ce que** le matériau du corps façonné est un matériau céramique supraconducteur à haute température.

3. Procédé selon la revendication 2, **caractérisé en ce que** le matériau du corps façonné ou/et le matériau de remplissage est constitué essentiellement d'éléments choisis parmi le groupe de Mg, Ca, Sr, Ba, Sc, Y, La, lanthanides, Zr, Hf, Pt, Pd, Ag, Cu, Hg, Ag, Tl, Pb, Bi, S et O.

4. Procédé selon la revendication 2 ou 3, **caractérisé en ce que** le matériau du corps façonné ou/et le matériau de remplissage est choisi parmi le groupe de matériaux à base de Bi-Ea-Cu-O, (Bi,Pb)-Ea-Cu-O, Y-Ea-Cu-O, (Y,SE)-Ea-Cu-O, TI-Ea-Cu-O, (TI,Pb)-Ea-Cu-O et Tl-(Y,Ea)-Cu-O, Ea désignant au moins un élément alcalino-terreux.

5. Procédé selon l'une des revendications 1 à 4, **caractérisé en ce que** l'on utilise un matériau de remplissage dans lequel au moins deux des paramètres de réseau du réseau cristallin ou moléculaire de l'une des phases principales du matériau de remplissage est suffisamment similaire à ceux de l'une des phases principales du matériau du corps façonné.

6. Procédé selon l'une des revendications 1 à 5, **caractérisé en ce que** le corps façonné se présente sensiblement sous la forme de plaques, de ronds, de parallélépipèdes, de cylindres pleins, de cylindres creux, d'anneaux, de tubes ou de bobines.

7. Procédé selon l'une des revendications 1 à 6, **caractérisé en ce que** le corps façonné est un corps de céramique obtenu par agglomération par frittage, frittage ou fusion, avec une densité relative d'au moins 80%, de préférence d'au moins 90%.

8. Procédé selon l'une des revendications 1 à 7, **caractérisé en ce qu'**en guise de matériau de remplissage on applique ou/et on introduit une poudre, ou/et un corps façonné compressé, calciné, fritté ou de fusion, ou/et un revêtement.

9. Procédé selon l'une des revendications 1 à 8, **caractérisé en ce que** l'on supprime une fissure, une limite de grain ou/et une zone d'impureté ou de structure perturbée, notamment par sciage, et **en ce que** la zone supprimée est ensuite traitée comme une fissure.

10. Procédé selon l'une des revendications 1 à 9, **caractérisé en ce que** le corps façonné avec le matériau de remplissage est maintenu à ladite température au moins jusqu'à ce que soit possible une pénétration au moins partielle du matériau de remplissage fusionné dans une fissure plus large ou dans une zone supprimée.

11. Procédé selon l'une des revendications 1 à 10, **caractérisé en ce que** les conditions thermiques de cristallisation pour le matériau de remplissage sont choisies de façon telle que le matériau de remplissage subisse une croissance épitaxiale sur la surface de la fissure, sur la surface d'une zone supprimée ou/et sur la surface du corps façonné.

12. Procédé selon l'une des revendications 2 à 11, **caractérisé en ce que** le corps façonné, lors du refroidissement ou/et lors d'un traitement thermique ultérieur, est enrichi en oxygène, et dans lequel on forme une phase supraconductrice.

13. Procédé selon l'une des revendications 2 à 12, **caractérisé en ce que** le corps façonné avec le matériau de remplissage échauffé subit un traitement thermique ultérieur dans un gaz renfermant de l'oxygène, en vue d'améliorer les propriétés de supraconductivité.

14. Procédé selon l'une des revendications 1 à 13, **caractérisé en ce que** le corps façonné avec le matériau de remplissage échauffé est soumis en surface, à un usinage mécanique de reprise.

15. Procédé selon l'une des revendications 1 à 14, **caractérisé en ce que** l'on utilise un corps façonné qui ne présente que peu de domaines magnétiques.

16. Procédé selon l'une des revendications 1 à 15, **caractérisé en ce que** l'on utilise un corps façonné qui a été fabriqué selon un processus de croissance de texture de fusion modifié ou un processus de croissance de fusion avec un germe situé dans le haut.

17. Procédé selon l'une des revendications 1 à 16, **caractérisé en ce que** l'on répare ou remédie à des domaines magnétiques fragmentés.

18. Procédé selon l'une des revendications 1 à 17, **caractérisé en ce que** le matériau du corps façonné ou/et le matériau de remplissage contient des phases qui sont choisies parmi les groupes de phases d'une composition approchante suivante Y₁Ba₂Cu₃Oᵥ, Y₂Ba₁Cu₁O_{w}, Yb₁Ba₂Cu₃O_{v'}, Yb₂Ba₁Cu₁O_{w'} , Sm₁Ba₂Cu₃O_{v"}, Sm₂Ba₁Cu₁O_{w"}, Nd₁Ba₂Cu₃O_{v"'}, Nd₄Ba₂Cu₂O_{w"'}, Y₂O₃, CeO₂, PtO₂, Ag et AgO₂, dans lesquels Y, Yb, Sm ou/et Nd peuvent être en partie également remplacés par d'autres lanthanides ou Y, et pour lesquels dans Ag ou/et AgO₂ peuvent également apparaître d'autres éléments chimiques voisins.

19. Procédé selon l'une des revendications 1 à 17, **caractérisé en ce que** le matériau du corps façonné ou/et le matériau de remplissage contient des phases qui sont choisies parmi les groupes de phases d'une composition approchante suivante Bi₂(Sr,Ca)₂Cu₁Oₓ, (Bi,Pb)₂(Sr,Ca)₂Cu₁O_{x'} , Bi₂(Sr,Ca)₃Cu₂O_{x"}, (Bi,Pb)₂(Sr,Ca)₃Cu₂O_{x"'}, Bi₂(Sr,Ca)₄Cu₃O_{x""}, (Bi,Pb)₂(Sr,Ca)₄Cu₃O_{x""'}, dans lesquels Bi, Pb, Sr et Ca peuvent être en partie également remplacés par d'autres éléments chimiques individuels.

20. Procédé selon l'une des revendications 1 à 17, **caractérisé en ce que** le matériau du corps façonné ou/et le matériau de remplissage contient des phases qui sont choisies parmi les groupes de phases d'une composition approchante suivante (Tl,Pb)₂(Ba,Ca)₂Cu₁O_{y}, (Tl,Pb)₂(Ca,Ba)₄Cu₃O_{y'}, (Tl,Pb)₂(Ca,Ba)₃Cu₄O_{y"}, (Tl,Pb)₁(Ca, Ba)₃Cu₂O_{y"'} et (Tl,Pb)₁(Ca, Ba)₄Cu₃O_{y""}, certains des éléments chimiques énumérés pouvant en partie également être remplacés par d'autres éléments chimiques.

21. Corps façonné avec seulement un ou jusqu'à 8 grains, dans lequel au moins une fissure ou/et au moins une zone d'impuretés ou de structure perturbée, qui a été supprimée auparavant du corps façonné, par exemple par sciage, ont été réparées avec le procédé selon l'une des revendications 1 à 20.

22. Corps façonné magnétique avec seulement un ou jusqu'à 8 domaines magnétiques, dans lequel au moins une fissure ou/et au moins une zone d'impuretés ou de structure perturbée, qui a été supprimée auparavant du corps façonné, par exemple par sciage, ont été réparées avec le procédé selon l'une des revendications 1 à 20.

23. Utilisation d'un corps façonné fabriqué selon l'une des revendications 2 à 15, pour des transformateurs, des sectionneurs de courant, des alimentations en courant, des blindages magnétiques, des paliers magnétiques ou/et en tant qu'aimants.
